# EUROPÄISCHE PATENTSCHRIFT

(11) **EP 3 580 845 B1**
(45) Veröffentlichungstag und Bekanntmachung des Hinweises auf die Patenterteilung: **12.01.2022**
(21) Anmeldenummer: 18750173.9
(22) Anmeldetag: 02.08.2018
(51) Int. Cl.: H02P 6/00, H03K 17/795, G08C 19/16, G08C 19/00, G08C 23/04, H04L 25/02

(54) **ANORDNUNG ZUR ÜBERMITTLUNG VON SOLLWERTSIGNALEN FÜR EINEN ELEKTRONISCH KOMMUTIERTEN MOTOR**
ARRANGEMENT FOR TRANSMITTING DESIRED VALUE SIGNALS FOR AN ELECTRONICALLY COMMUTATED MOTOR
ENSEMBLE DE TRANSMISSION DE SIGNAUX DE VALEUR THÉORIQUE POUR UN MOTEUR À COMMUTATION ÉLECTRONIQUE

(30) Priorität: 30.08.2017 DE 102017119947
(43) Veröffentlichungstag der Anmeldung: 18.12.2019
(73) Patentinhaber: ebm-papst Mulfingen GmbH & Co. KG, 74673 Mulfingen (DE)
(72) Erfinder: SCHNEIDER, Fabian, 74585 Rot am See (DE)
(74) Vertreter: Staeger & Sperling Partnerschaftsgesellschaft mbB
(86) Internationale Anmeldenummer: PCT/EP2018/071013
(87) Internationale Veröffentlichungsnummer: WO 2019/042701

(56) Entgegenhaltungen:
- EP-A1- 1 662 665
- EP-A2- 2 840 708
- DE-U1- 29 701 571
- US-A1- 2016 056 829

## Beschreibung

Die Erfindung betrifft eine Anordnung mit einem elektronisch kommutierten Motor, welcher im Betrieb von einem Wechselstromnetz über eine Kommutierungselektronik gespeist wird, mit einer Schnittstelle zur Eingabe von Sollwertsignalen für den Motor, wobei die Schnittstelle von der Kommutierungselektronik galvanisch getrennt ist.

Wenn bei derartigen Anordnungen zwischen dem elektronisch kommutierten Motor (EC-Motor) und dem Wechselstromnetz kein Transformator vorgesehen ist, ist der EC-Motor nicht galvanisch vom Wechselstromnetz getrennt, und dies erfordert besondere Schutzmaßnahmen, um bei etwaigen Isolationsschäden oder dergleichen eine Gefährdung des Benutzers auszuschließen.

Hierzu wird im Stand der Technik eine galvanische Trennung zwischen einer Schnittstelle zur Sollwertvorgabe (auch als Kundenschnittstelle oder Benutzerschnittstelle bezeichnet) und der Kommutierungselektronik vorgesehen. Im Stand der Technik ist z. B. ein Konzept bekannt, mit einer Anordnung bestehend aus einem elektronisch kommutierten Motor, welcher im Betrieb aus einem Wechselstromnetz z. B. über einen an dieses angeschlossenen Gleichrichter, und einen an diesen Gleichrichter angeschlossenen Gleichstrom-Zwischenkreis, mit einer Spannung versorgt wird und mit einer über einen Transformator aus diesem Wechselstromnetz gespeisten Anordnung zur Versorgung elektronischer Elemente des Motors mit einer Gleichspannung und mit einer zur Übermittlung von Informationen vom oder zum Motor vorgesehenen Benutzerschnittstelle, welche vom Motor galvanisch getrennt ist und welche einer vom Motor galvanisch getrennten Stromversorgung zugeordnet ist.

Durch die galvanische Trennung wird erreicht, dass die Benutzerschnittstelle potentialmäßig vom Motor und damit vom Wechselstromnetz getrennt ist, so dass eine Gefährdung des Benutzers bzw. Bedieners auch bei Störungen bzw. Schäden am Motor sicher ausgeschlossen wird.

Von der Benutzerschnittstelle kann ein analoges Eingangssignal als pulsweitenmoduliertes Signal von der Benutzerschnittstelle zum Motor z. B. über einen Trennübertrager, einen Lichtleiter, oder einen Optokoppler übertragen werden. So kann man der Benutzerschnittstelle z. B. ein analoges Signal für die gewünschte Drehzahl zuführen, dieses analoge Signal innerhalb der Benutzerschnittstelle in digitale Signale mit einem signalabhängigen Tastverhältnis umzusetzen, und diese digitalen Signale mit Hilfe eines Optokopplers zur Steuerelektronik des Motors übertragen, damit sie dort weiterverarbeitet werden können.

Üblicherweise wird ein solches analoges Sollwertsignal zunächst von einem Mikrocontroller oder IC auf der von der Netzversorgung galvanisch getrennten Seite der Kundenschnittstelle in ein digitales Signal gewandelt, welches anschließend über die galvanische Trennung übertragen und auf der Kommutierungsseite von einem zweiten Mikrocontroller (Kommutierungscontroller) ausgewertet wird. Das hierzu über die Trennstrecke übertragene Signal ist üblicherweise ein PWM-Signal. Die Information des analogen Sollwertes ist dabei in der zum Analogwert proportionalen Pulsweite des Signals enthalten (siehe z.B. EP 2 840 708 A2).

Bei der Übertragung mittels kostengünstigen Optokopplern tritt dabei durch die Signallaufzeiten (totzeitbehaftete Übertragung) eine Veränderung des Puls-Pausen-Verhältnisses, d. h. der Veränderung der Impulsdauer zur Pausendauer des PWM-Signals auf, welches die in der Pulsweite enthaltene Information verfälscht. Somit ist die Übertragungsgenauigkeit abhängig von den Signallaufzeiten und der daraus resultierenden Veränderung des Puls-Pausen-Verhältnisses beeinflusst.

Die Signallaufzeiten der Übertragungsstrecke (Optokoppler) sind zudem von weiteren Faktoren, wie auch stark von Temperatur und Alterung des Bauteils beeinflusst. Dies führt insgesamt zu einer falschen oder ungenauen analogen Sollwertbeeinflussung für das Gerät.

Es besteht daher ein Bedürfnis der Verbesserung der Übertragungsgenauigkeit bei der Übertragung eines analogen Sollwertsignals für einen EC-Motor von einer für analoge Sollwertvorgaben vorhandenen Schnittstelle zur Kommutierungselektronik mit galvanischer Trennung.

Der Erfindung liegt deshalb die Aufgabe zugrunde, vorbesagte Nachteil zu überwinden und eine Vorrichtung zu schaffen, die einerseits eine hohe elektrische Sicherheit für den Benutzer garantiert und andererseits gewährleistet, dass die Sollwertvorgaben mit hoher Genauigkeit an den Motor übertragen werden.

Diese Aufgabe wird durch die Merkmalskombination gemäß Anspruch 1 gelöst.

Ein Grundgedanke der vorliegenden Erfindung liegt darin, den analogen Sollwert nicht mehr als PWM-Signal über die Trennstrecke zu übertragen, bei welchem die Information in der Pulsweite enthalten ist, sondern mittels einer diskreten Schaltung auf der galvanisch getrennten Schnittstellenseite, bei der das analoge Signal in einen Bitstrom gewandelt, übertragen und auf der Kommutierungsseite zeitdiskret ausgewertet und in ein zum analogen Sollwert proportionales Signal zurück gewandelt wird.

Hierdurch wird die Problematik der Signallaufzeiten der Signale eliminiert und spielt demnach das Puls-Pausen-Verhältnisses keine Rolle mehr und die Übertragungsgenauigkeit wird von der Signallaufzeit unabhängig. Das auf der galvanisch getrennten Schnittstellenseite zur Umwandlung benötigte Taktsignal wird auf der nicht getrennten Kommutierungsseite erzeugt. Somit wird eine einfache Synchronisation der zeitdiskreten Auswertung auf den Bitstrom mit maximaler Genauigkeit ermöglicht.

Erfindungsgemäß ist daher eine Anordnung mit einem elektronisch kommutierten Motor mit einer Schnittstelle zur Eingabe von analogen Sollwertsignalen für den Motor vorgesehen, welcher im Betrieb von einem Wechselstromnetz über eine Kommutierungselektronik gespeist wird, wobei die Schnittstelle von der Kommutierungselektronik durch eine galvanische Trennung getrennt ist und wobei ferner zur Übertragung eines analogen Sollwertsignals eine Bitstrom-Signalerzeugungseinrichtung auf der galvanisch getrennten Schnittstellenseite vorgesehen ist und eine Übertragungseinrichtung zur Übertragung des erzeugten Bitstromes sowie eine Signalverarbeitungseinrichtung auf der galvanisch nicht getrennten Seite zur Signalauswertung des Bitstromes.

In einer bevorzugten Ausführungsform der Erfindung ist vorgesehen, dass die Bitstrom-Signalerzeugungseinrichtung auf der galvanisch getrennten Schnittstellenseite ein D-Flip-Flop, ein Integrator und ein Komparator ist. Eine ebenfalls vorteilhafte Ausgestaltung der Erfindung sieht vor, dass die Übertragungseinrichtung für den Bitstrom ein Optokoppler ist. Mit Vorteil können sehr kostengünstige, langsame Optokoppler eingesetzt werden. Weiter ist mit Vorteil vorgesehen, dass die Signalverarbeitungseinrichtung auf der galvanisch nicht getrennten Seite ein D-Flip-Flop, ein Oszillator, ein Inverter und ein Tiefpassfilter ist oder der Bitstrom mittels eines Mikrocontrollers ausgewertet wird. Besonders vorteilhaft kann auch eine ohnehin in der Kommutierungselektronik verwendeter Mikrocontroller hierzu eingesetzt werden.

Zur Erzeugung eines zeitdiskreten Bitstroms aus dem analogen Sollwertsignal ist gemäß der Erfindung ein Modul zur Erzeugung eines Taktsignals auf der galvanisch nicht getrennten Seite vorgesehen, um das analoge Sollwertsignal mittels des Taktsignals in ein Bitstromsignal zu wandeln. Ferner ist vorgesehen, dass die Signalverarbeitungseinrichtung so ausgebildet ist, das zeitdiskrete Bitstrom-Signal auszuwerten und für den Motor in ein dem analogen Signalwert proportionalen Signal umzuwandeln.

Ein weiterer Aspekt der vorliegenden Erfindung betrifft ein Verfahren zum Übertragen eines analogen Sollwertsignals von einer Schnittstelle über eine galvanische Trennung hinaus zu einem elektronisch kommutierten Motor mit einer wie zuvor beschriebenen Anordnung mit den folgenden Schritten:
a. Erzeugung eines Bitstromes auf der galvanisch getrennten Seite der Anordnung;
b. Übertragung des erzeugten digitalen Bitstromes über die galvanische Trennung hinaus und
c. Takterzeugung und Auswertung des Bitstromes auf der galvanisch nicht getrennten Seite zur Zuführung des daraus gewonnenen Signals an den Motor.

In einer bevorzugten Ausführungsform des Verfahrens ist vorgesehen, dass der Bitstrom im zuvor genannten Schritt a) mittels eines D-Flip-Flops, eines Integrators und eines Komparators erzeugt wird. Ebenfalls von Vorteil ist es, wenn ein Optokoppler zur Übertragung für den Bitstrom in Schritt b) verwendet wird.

Die Signalauswertung auf der galvanisch nicht getrennten Seite kann in vorteilhafter Weise mittels eines D-Flip-Flops, eines Oszillators, eines Inverters, eines Tiefpassfilters oder mittels eines Mikrocontrollers erfolgen. Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigt:

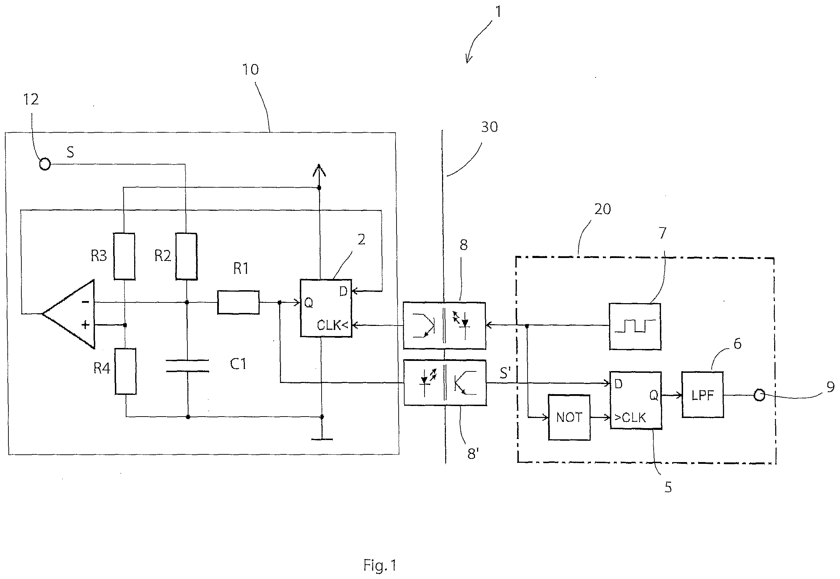

- Fig. 1: ein Blockschaltbild zur Erläuterung der gezeigten erfindungsgemäßen Anordnung.

Das Blockschaltbild in der Figur 1 zeigt eine Anordnung 1 für einen nicht dargestellten elektronisch kommutierten Motor mit einer Schnittstelle 10 zur Eingabe von analogen Sollwertsignalen S für den Motor, welcher im Betrieb von einem Wechselstromnetz über eine Kommutierungselektronik 20 gespeist wird, wobei die Schnittstelle 10 von der Kommutierungselektronik 20 durch die dazwischen dargestellte galvanische Trennung 30 galvanisch getrennt ist.

Die Kundenschnittstelle 10 umfasst ein Flip-Flop 2 zur Erzeugung eines Bitstromes aus einem analogen Sollwertsignal S, das am analogen Sollwerteingang 12 bereitgestellt wird.

Das Flip-Flop 2 arbeitet hier als Element der Bitstrom-Signalerzeugungseinrichtung auf der galvanisch getrennten Schnittstellenseite.

Ferner ist im Bereich der galvanischen Trennung 30 eine Übertragungseinrichtung 3 gezeigt, zur Übertragung des erzeugten Bitstromes über die galvanische Trennung 30 hinaus zur Kommutierungselektronik 20. Die Kommutierungselektronik 20 umfasst eine Signalverarbeitungseinrichtung 4, einen Flip-Flop 5 und einen Tiefpassfilter 6. Die Signalverarbeitungseinrichtung 4 umfasst ferner ein elektronisches Modul 7 zur Erzeugung eines Taktsignals, das, wie mit dem Pfeil in der Figur 1 angedeutet entgegen der Signalstrecke für das analoge Signal über einen Optokoppler 8 an das Flip-Flop 2 zur Erzeugung eines Bitstromes in Form eines zeitdiskreten Signals übergeben wird. Dieses Signal wird über den Optokoppler 8' über die galvanische Trennung 30 hinaus zur zeitdiskreten Signalauswertung an das Flip-Flop 5 über den Tiefpassfilter 6 zum Ausgang 9 geleitet.

Am Ausgang 9 der Signalverarbeitungseinrichtung 4, d. h. auf der galvanisch nicht getrennten Seite des Motors, wird das zum analogen Signal S nach der zeitdiskreten Signalauswertung proportionale Signal S' für einen elektronisch kommutierten Motor bereit gestellt.

Neben dem beschriebenen Ausführungsbeispiel ist eine Anzahl von Varianten, die im Schutzbereich der angefügten Ansprüche enthalten sind, denkbar, welche von der dargestellten Lösung auch bei grundsätzlich anders gearteten Ausführungen Gebrauch macht, so dass z. B. die Auswertung des getakteten Signals nach der Bitstrom-Signalerzeugung auf der galvanisch nicht getrennten Seite auch mittels eines entsprechend ausgebildeten Mikrocontroller geschehen kann.

## Patentansprüche

1. Anordnung (1) mit einem elektronisch kommutierten Motor mit einer Schnittstelle (10) zur Eingabe von analogen Sollwertsignalen (S) für den Motor, welcher im Betrieb von einem Wechselstromnetz über eine Kommutierungselektronik (20) gespeist wird, wobei die Schnittstelle (10) von der Kommutierungselektronik (20) durch eine galvanische Trennung (30) galvanisch getrennt ist, wobei ferner zur Übertragung eines analogen Sollwertsignals (S) eine Bitstrom-Signalerzeugungseinrichtung (2) auf der galvanisch getrennten Schnittstellenseite vorgesehen ist und eine Übertragungseinrichtung (3) zur Übertragung des erzeugten Bitstromes sowie eine Signalverarbeitungseinrichtung (4) auf der galvanisch nicht getrennten Seite zur Signalauswertung des Bitstromes, wobei die Signalverarbeitungseinrichtung (4) ausgebildet ist das zeitdiskrete BitstromSignal auszuwerten und für den Motor in ein dem analogen Sollwertsignal (S) proportionales Signal (S') umzuwandeln und wobei zur Erzeugung eines zeitdiskreten Bitstroms aus dem analogen Sollwertsignal (S) ein Modul zur Erzeugung eines Taktsignals auf der galvanisch nicht getrennten Seite vorgesehen ist, um ein analoges Sollwertsignal (S) mittels des Taktsignals in ein zeitdiskretes Bitstromsignal zu wandeln,

2. Anordnung (1) nach Anspruch 1, **dadurch gekennzeichnet, dass** die Bitstrom-Signalerzeugungseinrichtung (2) auf der galvanisch getrennten Schnittstellenseite ein D-Flip-Flop, ein Integrator und ein Komparator ist.

3. Anordnung (1) nach Anspruch 1 oder 2, **dadurch gekennzeichnet, dass** die Übertragungseinrichtung (3) für den Bitstrom ein Optokoppler ist.

4. Anordnung (1) nach Anspruch 1, 2 oder 3, **dadurch gekennzeichnet, dass** die Signalverarbeitungseinrichtung (4) auf der galvanisch nicht getrennten Seite ein D-Flip-Flop, ein Oszillator, ein Inverter oder ein Tiefpassfilter umfasst oder mittels eines Mikrocontrollers realisiert ist.

5. Verfahren zum Übertragen eines analogen Sollwertsignals (S) von einer Schnittstelle (10) über eine galvanische Trennung (30) hinaus zu einen elektronisch kommutierten Motor mit einer Anordnung gemäß einem der Ansprüche 1 bis 4, mit den folgenden Schritten:
a. Erzeugung eines Bitstromes auf der galvanisch getrennten Seite der Anordnung;
b. Übertragung des erzeugten digitalen Bitstromes über die galvanische Trennung (30) und
c. Takterzeugung und Auswertung des Bitstromes auf der galvanisch nicht getrennten Seite zur Zuführung des daraus gewonnenen Signals an den Motor.

6. Verfahren nach Anspruch 5, wobei der Bitstrom in Schritt a) mittels eines D-Flip-Flops, ein Integrators oder ein Komparators erzeugt wird.

7. Verfahren nach Anspruch 5 oder 6, wobei ein Optokoppler zur Übertragung für den Bitstrom verwendet wird.

8. Verfahren nach einem der Ansprüche 5 bis 7, wobei die Signalauswertung auf der galvanisch nicht getrennten Seite mittels eines D-Flip-Flops, eines Oszillators, eines Inverters, eines Tiefpassfilters oder mittels eines Mikrocontrollers erfolgt.

## Claims

1. Arrangement (1) having an electronically commutated motor with an interface (10) for inputting analogue desired value signals (S) for the motor, which in operation is fed from an alternating current network via a commutation electronics (20), wherein said interface (10) is galvanically isolated from said commutation electronics (20) by a galvanic separation (30), wherein furthermore for the transmission of an analogue desired value signal (S) a bit stream signal generating device (2) is provided on the galvanically isolated interface side and a transmission device (3) for the transmission of the generated bit stream as well as a signal processing device (4) on the galvanically non-isolated side for signal evaluation of the bit stream, wherein said signal processing device (4) is formed to evaluate the time-discrete bit stream signal and to convert said bit stream signal for the motor into a signal (S') proportional to the analogue desired value signal (S) and wherein for generating a time-discrete bit stream from the analogue desired value signal (S) a module for generating a clock signal is provided on the galvanically non-isolated side in order to convert an analogue desired value signal (S) by means of the clock signal into a time-discrete bit stream signal.

2. Arrangement (1) according to claim 1, **characterized in that** said bit stream signal generating device (2) on the galvanically isolated interface side is a D-flip-flop, an integrator and a comparator.

3. Arrangement (1) according to claim 1 or 2, **characterized in that** said transmission device (3) for the bit stream is an optocoupler.

4. Arrangement (1) according to claim 1, 2 or 3, **characterized in that** said signal processing device (4) comprises, on the galvanically non-isolated side, a D-flip-flop, an oscillator, an inverter or a low-pass filter, or is implemented by means of a microcontroller.

5. Method for transmitting an analog desired value signal (S) from an interface (10) via a galvanic separation (30) to an electronically commutated motor with an arrangement according to one of the claims 1 to 4, comprising the following steps:
a. Generating a bit stream on the galvanically isolated side of the arrangement;
b. Transmitting the generated digital bit stream across the galvanic separation (30); and
c. Clock generation and evaluation of the bit stream on the nongalvanically isolated side to supply the signal obtained therefrom to the motor.

6. The method of claim 5, wherein the bit stream in step a) is generated by means of a D-flip-flop, an integrator or a comparator.

7. Method according to claim 5 or 6, wherein an optocoupler is used for transmission for the bit stream.

8. Method according to any one of claims 5 to 7, wherein the signal evaluation on the electrically non-isolated side is performed by means of a D-flip-flop, an oscillator, an inverter, a low-pass filter or by means of a microcontroller.

## Revendications

1. Agencement (1), comprenant un moteur à commutation électronique, doté d'une interface (10) destinée à entrer des signaux de valeur de consigne analogiques (S) pour le moteur qui est alimenté en cours de fonctionnement par un réseau de courant alternatif par l'intermédiaire d'une électronique de commutation (20), l'interface (10) étant séparée galvaniquement de l'électronique de commutation (20) par une isolation galvanique (30), dans lequel en outre, pour la transmission d'un signal de valeur de consigne analogique (S), un dispositif de génération de signal de train de bits (2) est prévu sur le côté d'interface séparé galvaniquement, et un dispositif de transmission (3) pour la transmission du train de bits généré ainsi qu'un dispositif de traitement de signal (4) étant prévus sur le côté non séparé galvaniquement pour l'évaluation de signal du train de bits, le dispositif de traitement de signal (4) étant réalisé pour évaluer le signal de train de bits temporel discret et pour le convertir pour le moteur en un signal (S') proportionnel au signal de valeur de consigne analogique (S), et dans lequel, pour la génération d'un train de bits temporel discret à partir du signal de valeur de consigne analogique (S), un module de génération d'un signal d'horloge est prévu sur le côté non séparé galvaniquement afin de convertir un signal de valeur de consigne analogique (S) au moyen du signal d'horloge en un signal de train de bits temporel discret.

2. Agencement (1) selon la revendication 1, **caractérisé en ce que** le dispositif de génération de signal de train de bits (2) sur le côté d'interface séparé galvaniquement est une bascule D, un intégrateur et un comparateur.

3. Agencement (1) selon la revendication 1 ou 2, **caractérisé en ce que** le dispositif de transmission (3) pour le train de bits est un optocoupleur.

4. Agencement (1) selon la revendication 1, 2 ou 3, **caractérisé en ce que** le dispositif de traitement de signal (4) sur le côté non séparé galvaniquement comprend une bascule D, un oscillateur, un inverseur ou un filtre passe-bas, ou est réalisé au moyen d'un microcontrôleur.

5. Procédé de transmission d'un signal de valeur de consigne analogique (S) d'une interface (10) au-delà d'une séparation galvanique (30) à un moteur à commutation électronique comprenant un agencement selon l'une quelconque des revendications 1 à 4, comprenant les étapes suivantes consistant à :
a. générer un train de bits sur le côté galvaniquement séparé de l'agencement ;
b. transmettre le train de bits numérique généré par la séparation galvanique (30), et
c. générer une horloge et évaluer le train de bits sur le côté non séparé galvaniquement afin d'amener le signal ainsi obtenu au moteur.

6. Procédé selon la revendication 5, dans lequel le train de bits est généré à l'étape a) au moyen d'une bascule D, d'un intégrateur ou d'un comparateur.

7. Procédé selon la revendication 5 ou 6, dans lequel un optocoupleur est utilisé pour la transmission pour le train de bits.

8. Procédé selon l'une quelconque des revendications 5 à 7, dans lequel l'évaluation de signal sur le côté non séparé galvaniquement est effectuée au moyen d'une bascule D, d'un oscillateur, d'un inverseur, d'un filtre passe-bas ou au moyen d'un microcontrôleur.
